# EUROPEAN PATENT SPECIFICATION

(11) **EP 2 724 411 B1**
(45) Date of publication and mention of the grant of the patent: **10.06.2015**
(21) Application number: 12723516.6
(22) Date of filing: 20.04.2012
(51) Int. Cl.: H01M 8/04, H01M 8/24, H01M 8/12

(54) **AN OFFSET CONTROL ARRANGEMENT AND METHOD FOR CONTROLLING VOLTAGE VALUES IN A FUEL CELL SYSTEM**
OFFSET-STEUERANORDNUNG UND VERFAHREN ZUR STEUERUNG DER SPANNUNGSWERTE IN EINEM BRENNSTOFFZELLENSYSTEM
AGENCEMENT DE COMMANDE DE DÉCALAGE ET PROCÉDÉ DE COMMANDE DES VALEURS DE TENSION DANS UN SYSTÈME DE PILES À COMBUSTIBLE

(30) Priority: 23.06.2011 FI 20115669
(43) Date of publication of application: 30.04.2014
(73) Proprietor: Convion Oy, 02150 Espoo (FI)
(72) Inventor: ÅSTRÖM, Kim, FI-02460 Kirkkonummi (FI)
(74) Representative: LEITZINGER OY
(86) International application number: PCT/FI2012/050396
(87) International publication number: WO 2012/175784

(56) References cited:
- EP-A2- 2 293 404
- WO-A1-2011/004057
- WO-A1-2011/004058
- US-A1- 2008 075 988

## Description

### The field of the invention

Especially because of the environmental problems, new energy sources, that are environmentally friendly and having good efficiency, have been developed. Fuel cell devices are promising future energy conversion devices by means of which fuel, for example bio gas, is directly transformed to electricity via a chemical reaction in an environmentally friendly process.

### The state of the art

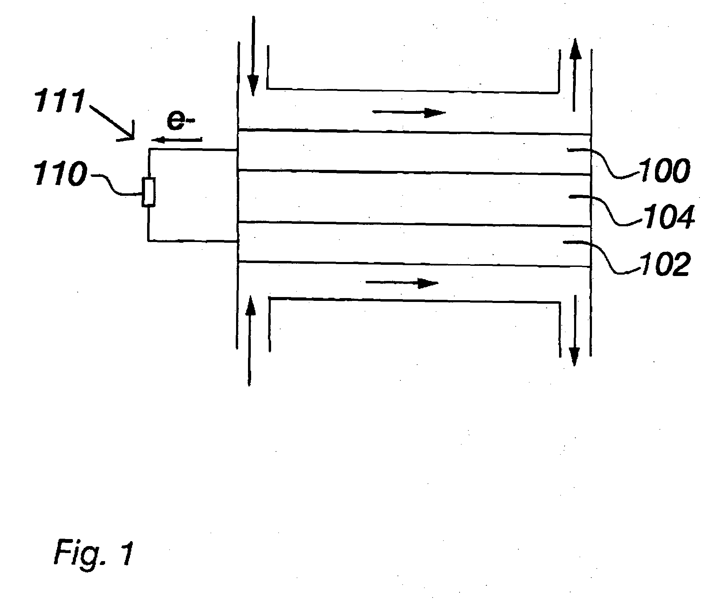

Fuel cell, as presented in fig 1, comprises an anode side 100 and a cathode side 102 and an electrolyte material 104 between them. In solid oxide fuel cells (SOFCs) oxygen is fed to the cathode side 102 and it is reduced to a negative oxygen ion by receiving electrons from the cathode. The negative oxygen ion goes through the electrolyte material 104 to the anode side 100 where it reacts with the used fuel producing water and also typically carbon dioxide (CO₂). Between the anode 100 and the cathode 102 is an external electric circuit 111 comprising a load 110 for the fuel cell.

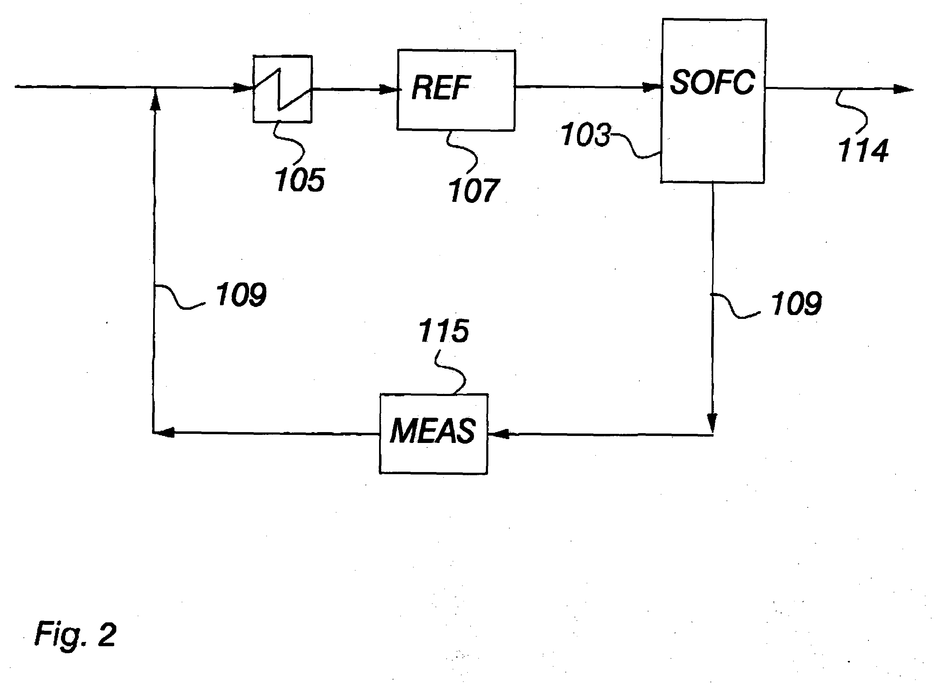

In figure 2 is presented a SOFC device as an example of a high temperature fuel cell device. SOFC devices can utilize for example natural gas, bio gas, methanol or other compounds containing hydrocarbon mixtures as fuel. SOFC device system in figure 2 comprises of more than one, typically multiple fuel cells in one or more stack formation 103 (SOFC stack(s)). A larger SOFC device system comprises many fuel cells in several stacks 103. Each fuel cell comprises of anode 100 and cathode 102 structures as presented in figure 1. Part of the used fuel may be recirculated in feedback arrangement 109. SOFC device in fig 2 also comprises a fuel heat exchanger 105 and a reformer 107. Heat exchangers are used for controlling thermal conditions in the fuel cell process and there can be more than one of them in different locations of a SOFC device. The extra thermal energy in circulating gas is recovered in one or more heat exchangers 105 to be utilized in the SOFC device or externally. Reformer 107 is a device that converts the fuel such as for example natural gas to a composition suitable for fuel cells, for example to a composition containing all or at least some of the following: hydrogen, methane, carbon dioxide, carbon monoxide, inert gases and water. Anyway in each SOFC device it is though not necessary to have a reformer.

By using measurement means 115 (such as fuel flow meter, current meter and temperature meter) necessary measurements for the operation of the SOFC device are carried out. Only part of the gas used at the anodes 100 is recirculated in the feedback arrangement 109 and the other part of the gas is exhausted 114 from the anodes 100.

Fuel cells are electrochemical devices converting the chemical energy of reactants directly to electricity and heat. Fuel cell systems have the potential to significantly exceed the electrical and CHP (Combined production of Heat and Power) efficiency of traditional energy production technologies of comparable size. Fuel cell systems are widely appreciated as a key future energy production technology.

In order to maximize the performance and lifetime of fuel cell systems accurate control of the fuel cell operating conditions is required. Fuel cells produce DC current whereas in higher power systems typically AC output is desired and thus a power conversion from DC to AC is required. To allow for practical interfacing and current collection from the fuel cells and subsequent power conversion, the fuel cells are manufactured as stacks containing several series connected individual cells.

In fuel cell systems comprising of several stacks, the electrical interconnection topology of the stacks is a key design parameter. Series connection of several stacks provides for lower cabling and power conversion losses as well as lower cost for components. Electrical isolation limitations as well as the preferred operating voltage level of the fuel cell load typically, however, limit the feasible amount of stacks to be serially connected. Hence, if higher power levels are required than what can be achieved with a single string of serial connected stacks, some sort of parallel connection of stacks or groups of stacks becomes a necessity.

When electrical sources such as fuel cells are connected in parallel, uneven load sharing may occur if there are deviations in the electrical characteristics of the individual sources. With fuel cells, this is a significant issue since uneven load sharing may reduce the efficiency, due to reduced fuel utilization, and/or significantly deteriorate those fuel cells operating above the average current. Due to inherent variances in series resistance between stacks as well as variations due to age, temperature etc, uneven load sharing to some extent is typically to be expected if stacks are connected directly in parallel. Electrical parallel connection of stacks is particularly problematic in high temperature fuel cell systems due to intrinsic negative temperature coefficient of their internal resistance. This characteristic gives rise to a positive feedback behaviour in the load sharing balance between parallel connected stacks ,i.e. a stack with higher current heats up, which tends to increase the current further due to decreased internal resistance. To avoid the current sharing issues, separate converters for each stack or series of stacks are often used, bringing a considerable higher cost to the system.

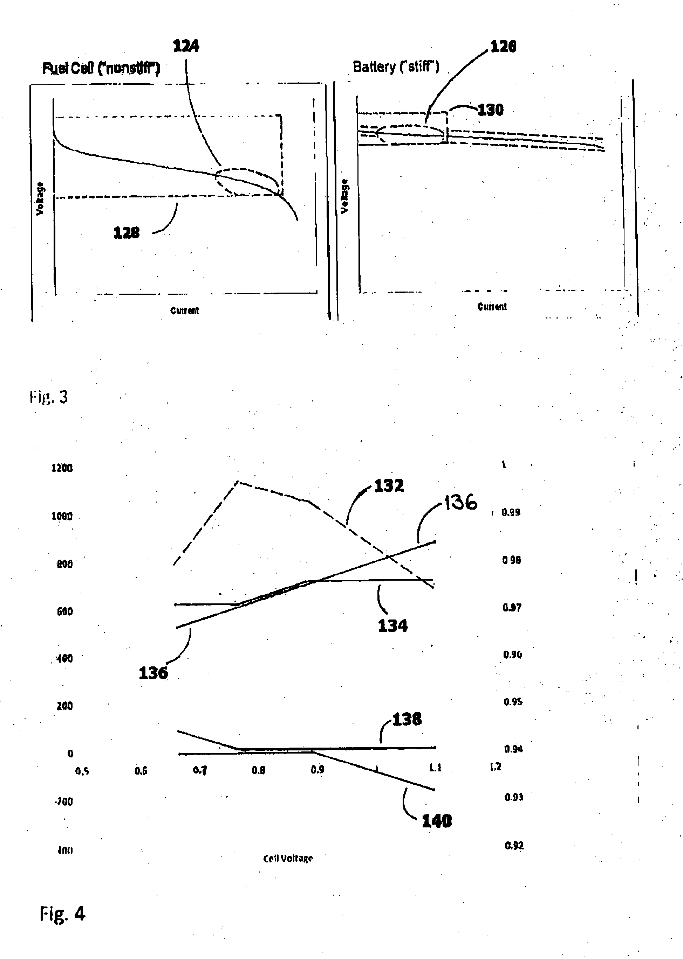

Fuel cells typically have current-voltage characteristics which are far more non-stiff than that of a battery. Typical shape and full operating range 128 of the fuel cell and for comparison typical shape and full operating range 130 of a battery are presented in figure 3. As seen from the figure 3 typically the voltage level at the nominal operation point 124 of the fuel cell is significantly lower than the maximum voltage of the fuel cell achieved in no- or low-load conditions. Reference number 130 represents the nominal operation window of the battery whereas number 128 depicts the operating window for a fuel cell. As a consequence, power electronics or more generally loads interfacing with the fuel cells need to deal with a comparatively wide operating voltage window. Fuel cell degradation occurring over the lifetime of the system further reduces voltages at full load, requiring an even wider operating window. For power electronics a large voltage window typically requires several compromises in terms of component selection and filter dimensioning both negatively affecting price and efficiency. For example, if the nominal operating operating window for a fuel cell is e.g. 0.6-0.8V/cell and open circuit voltage e.g. 1.1V/cell, power electronic components need to be dimensioned according to the highest voltage although operated most of the time at clearly lower voltage.

Large fuel cell systems typically incorporate a 3-phase inverter for feeding power to a grid or 3-phase load. For an inverter the optimum input voltage, i.e. DC-link voltage is the minimum voltage at which undistorted output can be generated. The theoretical minimum voltage is the main voltage multiplied by sqrt(2) i.e. 566V for a 400VAC grid connection. On top of this voltage a reasonable voltage margin is required to compensate for voltage drops in filters and switches and grid voltage variations. A typical DC-link setpoint for a 400VAC inverter is 625V. Operation above this voltage yields higher switching and filtering losses and higher electromagnetic emissions whereas operation below this voltage may result in a distorted output. The maximum allowable voltage is determined by the voltage rating of inverter components, typically 800V for a 400VAC inverter whereby the maximum voltage, applying a safety margin of 20% is 720V.

Feeding power from a fuel cell to an inverter is typically carried out in either by direct connection to the inverter (or other load) or by feeding the fuel cell power through a DC/DC converter stage. If a DC/DC converter is used then the voltage window matching can be done on the DC/DC side and inverter voltage kept at optimum at all times. Separate DC/DC converters can be used for different groups of fuel cell stacks, whereby each DC/DC converter can control the current of the corresponding stack group to mitigate uneven current sharing issues common for parallel connection of stacks. Disadvantages of introducing said separate DC/DC converters are conversion losses and additional economical cost associated with said separate converters.

If fuel cells are connected directly to the load (e.g. inverter) then their voltage, i.e. number of cells, has to be chosen such that the output voltage is sufficient even with the minimum output voltage from the fuel cells i.e. maximum load. Assuming a minimum cell voltage of 0.65, 961 cells are required to produce an inverter voltage of 625V. At no-load conditions with cell voltage e.g. 1.1V the output voltage is 1058V. This requires the use of at least 1200V rated components in the inverter, preferably even higher voltage rating rather than 800V components. Furthermore, the inverter operates at the optimum voltage only at end of life conditions. These compromises add costs and decrease efficiency of the inverter. An additional disadvantage is the lack of active means to control the current sharing between stacks connected in parallel. Particularly high temperature fuel cells are susceptible to uneven current sharing in such a case as their series resistance has a negative temperature coefficient causing differences in current sharing. The stack or group of stacks providing a higher load may be overstressed and suffer accelerated non-reversible degradation.

WO 2011/004057 A1 discloses a fuell cell system known by the art.

### Short description of the invention

The object of the invention is to improve efficiency and controllability of a fuel cell system economical friendly and by even having a possibility to get the physical size of the fuel cell system more compact. This is achieved by an offset control arrangement for controlling voltage values in a fuel cell system for producing electricity with fuel cells, each fuel cell in the fuel cell system comprising an anode side, a cathode side and an electrolyte between the anode side and the cathode side, the fuel cell system comprising at least one fuel cell array of at least two fuel cells, and at least one load for performing load function. The offset control arrangement comprises voltage monitoring means for monitoring input voltage of the load to obtain monitoring information, a control processor for processing said monitoring information, at least one offsetting source in serial connection to the at least one fuel cell array, power level of the offsetting source being substantially low compared to the power level of the fuel cell array, and the offsetting source is being arranged to perform at least unidirectional shifting of fuel cell array output voltage to reduce voltage window apparent to the load on the basis of at least one of the monitoring information and the processed monitoring information, and the offset control arrangement further comprises means for disconnecting the at least one fuel cell array from the load, when a reason for the disconnection is detected in the fuel cell system.

The focus of the invention is also an offset control method for controlling voltage values in a fuel cell system for producing electricity with fuel cells, each fuel cell in the fuel cell system comprising an anode side, a cathode side and an electrolyte between the anode side and the cathode side. In the method is monitored input voltage of a load of the fuel cell system to obtain monitoring information, which is processed, at least one offsetting source is connected in serial connection to an at least one fuel cell array, power level of the offsetting source being substantially low compared to the power level of the fuel cell array, and at least unidirectional shifting of fuel cell array output voltage is performed by the at least one offsetting source to reduce voltage window apparent to the load on the basis of at least one of the monitoring information and the processed monitoring information, and the at least one fuel cell array is disconnected from the load, when a reason for the disconnection is detected in the fuel cell system.

The invention is based on an offset controlling arranged in serial connection to an at least one fuel cell array in a fuel cell system, power level of the offsetting being substantially low compared to the power level of the fuel cell array. At least unidirectional shifting of fuel cell array output voltage is arranged by said offsetting to reduce voltage window apparent to the load on the basis of monitored information of input voltage of a load of the fuel cell system. The invention is further based on disconnecting the at least one fuel cell array from the load, when a reason for the disconnection is detected in the fuel cell system.

The benefit of the invention is that by utilizing a considerably small amount of compensating power according to the invention can be achieved a needed control capacity with significant savings in economical cost, physical size and operation power losses. Benefits of the present invention also include improved controllability and hence most likely improved lifetime of the fuel cells.

### Short description of figures

- Figure 1: presents a single fuel cell structure.
- Figure 2: presents an example of a SOFC device.
- Figure 3: presents typical shape and operating range of the fuel cell and for comparison typical shape and operating range of a battery.
- Figure 4: presents example voltage curves of the fuel cell array 103, DC-link, and positive and negative offsetting sources 140b, 140a according to the invention.
- Figure 5: presents an exemplary preferred embodiment according to the present invention.

### Detailed description of the invention

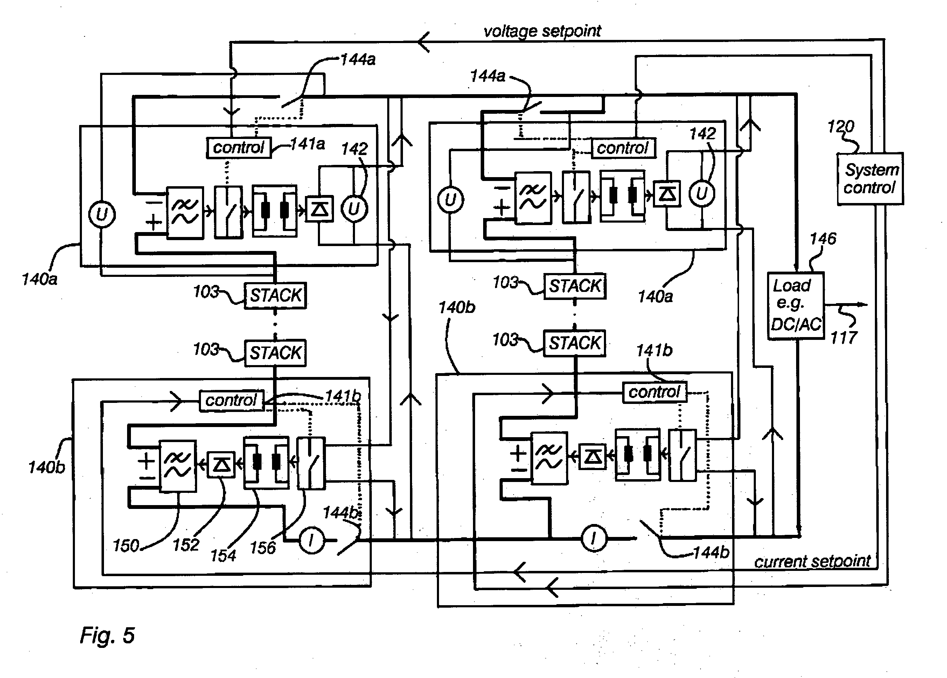

The arrangement according to the invention comprises offsetting sources 140 (Fig 5), which are dimensioned to be able to together source or sink a voltage in the range of to e.g. -0.2V/cell up to e.g. 0.13V/cell, i.e. to provide a respective compensational offset voltage to the voltage of the fuel cell array 103. Placed in series with a fuel cell array and designed for accurate and rapid control of the total output voltage of the series, the output voltage of the fuel cell array combined with said offsetting sources 140 can be reduced from e.g. 0.65-1.1V per cell to effectively 0.78 - 0.9V per cell from the load's perspective. For e.g. 800 cells this translates to a voltage window of 624-720V, which is i.e. the acceptable voltage window for a typical 400VAC inverter with 800V rated components. Since the voltage sourced or sank in the compensation source is only a fraction of the total cell voltage and the current is the same as for the fuel cell array, the power rating of the offsetting source is also only a fraction of that of the fuel cell array. Consequently, cost and losses are also only a fraction compared to a separate DC/DC converter handling the full power of the individual fuel cell array.

When the arrangement according to the invention comprises several fuel cell arrays 103, a separate offsetting source 140 can be arranged for each array. Thereby the sources connected to different arrays can be configured to provide different offset voltages to compensate for possible differences in voltage of the arrays. Therefore the invention inherently also provides efficient means for actively controlling current sharing between essentially paralleled fuel cell arrays at a low cost. However, the benefits of the method and arrangement of this invention are not limited to current sharing compensation, whereas the applicant's previous patent application FI20095776 concentrates on current sharing compensation issues.

The arrangement according to the present invention is capable of providing a significant voltage, which is yet small in comparison to fuel cell array voltage The arrangement is also combined with a sophisticated control processor. This arrangement can provide instantaneous voltage offsetting, which is large enough to reduce the effective voltage window of a fuel cell array to within acceptable variation bounds for a standard inverter.

In figure 5 is presented an exemplary preferred embodiment according to the present invention. In the following description is also described a detailed one preferred embodiment with exemplary numerical values. The offset compensation voltage range can be unipolar, e.g. 0-0.3V/cell strictly upward or downward compensation. In this example, the fuel cell stack array 103 can be dimensioned to provide e.g. 720V at open circuit conditions i.e. approximately 655 cells whereby the minimum voltage would be 0.65V*654=426V whereby an offset of 199V or approx 0.3V/cell upward would be required at minimum voltage conditions. Alternatively the cell could be traditionally dimensioned to produce 625V at minimum voltage conditions, i.e. 961cells, whereby at open load conditions the offset compensation requirement is 961*1.1V-720V = 337V or approximately 0.35V/cell downward. For an optimum performance, however a bipolar offset compensation is proposed, minimizing the power rating of the offsetting source(s) 140 (140a, 140b in Fig 5) and need for compensation during typical operating conditions. A bipolar offset compensation capability can be realized with a single device capable of bipolar output voltage or alternatively two unipolar devices in series, with mutually reversed polarities. For the preferable compensation voltage range stated of approximately -0.12V/cell - 0.2V/cell previously, voltage compensation is required in the ranges Ucell > 0.9V or Ucell < 0.77V. Therefore, a large part of the typical operation range i.e. 0.75-0.85V can be handled without compensation and hence virtually without loss. For the downward compensation voltage range Ucell>0.9V cell currents are less than nominal, presumably 50-60% or less than nominal, whereby the power rating required for a -0.2V negative offset value is essentially equal to the power rating corresponding to a 0.12V positive offset value at full current.

If two offsetting sources 140 are connected in series, for stability reasons one should be voltage controlled whereas the other one could be voltage controlled as well or implement current control to facilitate accurate active current sharing control. For instance, the negative offsetting source 140a can be voltage controlled and active during start-up whereas the positive offsetting source 140b can operate in current controlled mode all the time. Thus, except for purely open circuit conditions when positive voltage offsetting on top of the negative voltage offsetting may not be allowed, current sharing control is accomplished by the at least one positively offsetting source 140b. A multiple stack array 103 configuration could be arranged such that each array 103 has a dedicated positively offsetting source 140b whereas a common negatively offsetting source 140a is used.

Referring to the exemplary preferred embodiment of figure 5, the inverter 146 shall operate in a voltage controlled mode where the voltage of the DC-link is maintained at a setpoint provided by the fuel cell system control processor 120. In start-up conditions, the DC-voltage setpoint shall be the maximum value, i.e. for example 720V whereby the negatively offsetting source can provide up to open circuit voltage for the fuel cells. Control, i.e. increasing of the stack current is then accomplished by controlling, i.e. reducing the voltage setpoint of the negatively offsetting source 140a, whereby current starts flowing from the stacks to the load, and by this way an inverting operation is accomplished. To facilitate current sharing control the control processor provides a current setpoint to the positively offsetting source 140b and controls the voltage of the negatively offsetting source 140a such that for the best performing stack array 103 little or no positive offsetting is required. As current is ramped up the negatively offsetting voltage then gradually decreases down to zero whereafter voltage reduction can continue by reducing the DC-link setpoint down towards its minimum (625V) according to the best performing stack array. As the minimum DC-link voltage is reached and stack voltage continues to drop, the positively offsetting sources 140b, operating in current controlled mode, will then start supplying more and more positive voltage offset to maintain the desired current. Thus the voltage of the stack arrays can decrease below the minimum DC-link voltage until the worst performing array has reached the minimum average cell voltage, i.e. 0.65V => 520V for 800cells.

Example voltage curves of the fuel cell stack array 103, DC-link, and positive and negative offsetting sources 140b, 140a according to the principles of the invention are presented in figure 4. Reference number 132 represents efficiency curve, 134 represents voltage curve of the DC-link, 136 represents fuel cell voltage curve, 138 represents positive offset curve and 140 represents negative offset curve. Related to figure 4 is assumed that the difference in voltage between different arrays 103 is on average 10V, which is compensated at all voltage levels by the positive offsetting source 140b. The energy throughput efficiency from the stacks has been calculated assuming a very moderate conversion efficiency of 90% for the compensating sources, a minimum voltage loss of 1.0V for each of the compensation sources and an incremental inverter loss of 0.5% when operating at 720V rather than 625V.

As seen from the figure 4 a throughput efficiency in excess of 99% is achieved at a large part of the nominal operating range whilst still maintaining individual current controllability of each stack array. By increasing the modest efficiency of the DC/DC converters or by adding bypass contactors over the offsetting sources when either source is inactive, the efficiency can easily be even further improved.

In prior art solutions where a 1200V or 1300V rated inverter would be needed to supply a 400V grid, the losses due to off-optimal operating voltage and off-optimal power electronics components are estimated to be in the range of 2-4%. Thus, from an overall power throughput point of view, the presented method and arrangement has a slight efficiency benefit. The benefits are, however, not only limited to efficiency but also include reduced cost due to the ability to use standard 800V inverter gear as well as improved controllability and hence most likely improved lifetime of stacks. Compared to the prior art arrangement with individual buck or boost DC/DC converters separately for each stack array both efficiency and cost characteristics are clearly better in the presented arrangement according to the invention.

Proper means 144 for disconnecting the fuel cell stack arrays 103 from the inverter 146 in fault situations are crucial for the operability and safety of the arrangement. The inverter input voltage must be actively monitored and disconnection must take place within tens of milliseconds if the voltage rises out of allowed bounds. Preferably, voltage monitoring means 142 of the inverter 146 DC-link can be included in the negatively offsetting source 140a by utilizing as said monitoring means 142 a control circuitry 141 of the negatively offsetting source 140a, which control circuitry 141 controls a first main fuel cell array contactor 144a (Fig. 5) as said means 144 for disconnecting the fuel cell stack arrays 103 from the inverter 146. Thus, immediate disconnection can take place without requiring immediate action from the fuel cell system control processor 120 in case of a sudden voltage rise due to e.g. loading discontinuation of stacks or failure in one or more of the offsetting sources 140a, 140b. A second contactor 144b for bipolar disconnection of the FC stack could be controlled by the same signal or alternatively controlled separately by e.g. monitoring means 142 in the positively offsetting source 140b.

In the following is described summarized description of the preferred embodiment presented in figure 5. A fuel cell array 103 comprises preferably at least two serial connected fuel cell stacks, and the fuel cell system can have two or more parallel connected fuel cell arrays 103. The fuel cell system comprises at least one load 146 for performing load function, and in the preferred embodiment the load is an inverter, e.g. a DC/AC inverter, for performing inverting operations. The offset control arrangement comprises voltage monitoring means 142 for monitoring input voltage of the inverter 146 to obtain monitoring information, and a fuel cell system control processor 120 for processing said monitoring information. The offset control arrangement further comprises offsetting sources 140a, 140b in serial connections to the at least one fuel cell array 103, power level of the offsetting sources 140a, 140b being substantially low compared to the power level of the fuel cell array 103. In the preferred embodiment of the invention these offsetting sources, i.e. the negatively offsetting source 140a and the positively offsetting source 140b are being arranged to perform bidirectional shifting, i.e. negative and positive offset, of fuel cell array output voltage to reduce voltage window apparent to the inverter 146 on the basis of at least one of the monitoring information and the processed monitoring information. The control circuitry 141 of the negatively offsetting source 140a is preferably utilized as said monitoring means 142, which control circuitry 141 controls an at least one main fuel cell array contactor 144a, which is used as means 144 for disconnecting the at least one fuel cell array 103 from the load 146, when a reason for such disconnection is detected in the fuel cell system by said monitoring.

In the preferred embodiment according to the invention the offset control arrangement comprises at least one separate offsetting source 140, for each array 103 for providing individual offset values to compensate for differences in voltage values between the arrays 103. The preferred offset control arrangement comprises a positive offsetting source 140b for providing at least positive offsetting value for the at least one fuel cell array 103 primarily for end of life operation, and a negative offsetting source 140a for providing at least negative offsetting value for the at least one fuel cell array 103 primarily to eliminate substantially high voltage peaks of the inverter 146. In one preferred embodiment the offset control arrangement comprises a separate positively offsetting source 140b for each fuel cell array 103, and a common negatively offsetting source 140a for all arrays 103 or for most of the arrays 103.

Next will be explained common symbols inside offsetting source boxes (140a, 140b): Reference sign 150 refers to filtering stage, 152 refers to rectification stage, 154 refers to high frequency transforming stage and 156 refers to a stage of controllable switches.

Furthermore in the preferred embodiment the offset control arrangement comprises the fuel cell system control processor 120 for accomplishing current sharing control between the at least two fuel cell arrays 103 by providing at least one of current setpoint and voltage setpoint to a positively offsetting source 140b for continuous operation of the fuel cell system, and by controlling at least one of voltage and current of a negatively offsetting source 140a so that for the best performing fuel cell array 103 little or no positive offsetting is accomplished. Said negatively offsetting source 140a is primarily active during start-up process of the fuel cell system.

In embodiments according to the invention the offset control arrangement can comprise a single offsetting source 140 capable of bipolar output voltage for performing bipolar offset compensation of the fuel cell array 103. Also according to the invention the offset control arrangement can comprise two unipolar offsetting sources 140 in series and with mutually reversed polarities for performing bipolar offset compensation of the array 103.

The use of the offsetting voltage source 140a, 140b principle is not limited to the grid voltages, number of cells and/or cell voltage range provided above as examples. The principle can be scaled to be applied for any grid voltage (e.g. 200V up to 480V) and fuel cell technology. Also, the principles according to the invention can be used for systems connected to a mid-voltage utility through a transformer. The control processor 120 can comprise of different kind of analogical and/or digital electronics implementations that are for example based on a programmable processor.

As well as described with SOFCs the present invention can also be utilized with MCFCs (Molten Carbonate Fuel Cells) and other fuel cells. MCFCs are high temperature fuel cells that use an electrolyte composed of a molten carbonate salt mixture suspended in a porous, chemically inert ceramic matrix. Also the fuel cell system, where this invention is utilized, does not need to have a feedback arrangement though the feedback arrangement is described in SOFC device example in figure 2.

Although the invention has been presented in reference to the attached figures and specification, the invention is by no means limited to those, as the invention is subject to variations within the scope allowed for by the claims.

## Claims

1. An offset control arrangement for controlling voltage values in a fuel cell system for producing electricity with fuel cells, each fuel cell in the fuel cell system comprising an anode side (100), a cathode side (102) and an electrolyte (104) between the anode side and the cathode side, the fuel cell system comprising at least one fuel cell array (103) of at least two fuel cells, and at least one load (146) for performing load function, wherein the offset control arrangement comprises voltage monitoring means H (142) for monitoring input voltage of the load (146) to obtain monitoring information, a control processor (120) for processing said monitoring Information, at least one offsetting source (140) In serial connection to the at least one fuel cell array (103), power level of the offsetting source (140) being substantially low compared to the power level of the fuel cell array (103), and the offsetting source (140) is being arranged to perform at least unidirectional shifting of fuel cell array output voltage to reduce voltage window apparent to the load (146) on the basis of at least one of the monitoring information and the processed monitoring information, **characterized by**, that the offset control arrangement further comprises means (144) for disconnecting the at least one fuel cell array (103) from the load (146), when a reason for the disconnection is detected in the input voltage monitoring of the load by detecting that the input voltage rises out of allowed bounds.

2. An offset control arrangement in accordance with claim 1, **characterized by**, that the fuel cell system comprises at least two electrically parallel connected fuel cell arrays (103), and the offset control arrangement comprises at least one separate offsetting source (140) for each array (103) for providing individual compensation for each array.

3. An offset control arrangement in accordance with claim 1, **characterized by**, that the offset control arrangement comprises a negative offsetting source (140a) for providing at least negative offsetting value for the at least one fuel cell array (103).

4. An offset control arrangement in accordance with claim 1, **characterized by**, that the offset control arrangement comprises a positive offsetting source (140b) for providing at least positive offsetting value for the at least one fuel cell array (103) primarily for end of life operation.

5. An offset control arrangement in accordance with claim 2, **characterized by**, that the offset control arrangement comprises one separate offsetting source (140) for each fuel cell array (103), and a common offsetting source. (140) of opposite polarity than said separate offsetting source for all arrays (103) or for most of the arrays (103).

6. An offset control arrangement in accordance with claim 2, **characterized by**, that the offset control arrangement comprises the control processor (120) for accomplishing current sharing control between the at least two fuel cell arrays (103) by providing at least one of current setpoint and voltage setpoint to a positively offsetting source (140b) for continuous operation of the fuel cell system and by controlling at least one of voltage and current of a negatively offsetting source (140a) so that for the best performing fuel cell array (103) little or no positive offsetting is accomplished, and which negatively offsetting source (140a) is primarily active during start-up process of the fuel cell system.

7. An offset control arrangement in accordance with claim 1, **characterized by**, that the offset control arrangement comprises the voltage monitoring means (142) in the negatively offsetting source (140a) by utitizing a control circuitry (141) of the negatively offsetting source (140a) as said monitoring means (142), which control circuitry (141) controls at least one main fuel cell array contactor (144) as said means (144) for disconnecting the at least one fuel cell array (103) from the load (146), when a reason for the disconnection is detected in the fuel cell system by said monitoring.

8. An offset control arrangement in accordance with claim 1, **characterized by**, that the offset control arrangement comprises a single offsetting source (140) capable of bipolar output voltage for performing bipolar offset compensation.

9. An offset control arrangement in accordance with claim 1, **characterized by**, that the offset control arrangement comprises two unipolar offsetting sources (140) in series and with mutually reversed polarities for performing bipolar offset compensation.

10. An offset control method for controlling voltage values in a fuel cell system for producing electricity with fuel cells, each fuel cell in the fuel cell system comprising an anode side (100), a cathode side (102) and an electrolyte (104) between the anode side and the cathode side, wherein in the method is monitored input voltage of a load (146) of the fuel cell system to obtain monitoring information, which is processed, at least one offsetting source (140) is connected in serial connection to an at least one fuel cell array (103), power level of the offsetting source (140) being substantially low compared to the power level of the fuel cell array (103), and at least unidirectional shifting of fuel cell array output voltage is performed by the at least one offsetting source (140) to reduce voltage window apparent to the load (146) on the basis of at least one of the monitoring information and the processed monitoring information, **characterized by**, that the at least one fuel cell array (103) is disconnected from the load (146), when a reason for the disconnection is detected in the input voltage monitoring of the load by detecting that the input voltage rises out of allowed bounds.

11. An offset control method In accordance with claim 10, **characterized by**, that at least unidirectional shifting of fuel cell array output voltage is performed by at least one separate offsetting source (140) in at least two electrically parallel connected fuel cell arrays (103) to provide individual compensation for each array.

12. An offset control method in accordance with claim 10, **characterized by**, that at least negative offsetting value is provided for the at least one fuel cell array (103) by a negative offsetting source (140a).

13. An offset control method In accordance with claim 10, **characterized by**, that at least positive offsetting value is provided for the at least one fuel cell array (103) primarily for end of life operation by a positive offsetting source (140b).

14. An offset control method in accordance with claim 10, **characterized by**, that in the method is used one separate offsetting source (140) for each fuel cell array (103), and a common offsetting source (140) of opposite polarity than said separate offsetting source is used for all arrays (103) or for most of the arrays (103).

15. An offset control method in accordance with claim 10, **characterized by**, that current sharing control is accomplished between at least two fuel cell arrays (103) by providing at least one of current setpoint and voltage setpoint to a positively offsetting source (140b) for continuous operation of the fuel cell system and by controlling at least one of voltage and current of a negatively offsetting source (140a) so that for the best performing fuel cell array (103) little or no positive offsetting is accomplished, and which negatively offsetting source (140a) is primarily active during start-up process of the fuel cell system.

16. An offset control method in accordance with claim 10, **characterized by**, that in the method is monitored input voltage of a load (146) of the fuel cell system by using a control circuitry (141) of a negatively offsetting source (140a) in said monitoring to control at least one main fuel cell array contactor (144) for disconnecting the at least one fuel cell array (103) from the load (146), when a reason for the disconnection is detected in the fuel cell system by said monitoring.

17. An offset control method in accordance with claim 10, **characterized by**, that in the method is utilized bipolar output voltage of the single offsetting source (140) to perform bipolar offset compensation.

18. An offset control method in accordance with claim 10, **characterized by**, that in the method is connected two unipolar offsetting sources (140) in series with mutually reversed polarities to perform bipolar offset compensation.

## Patentansprüche

1. Offset-Steueranordnung zur Steuerung der Spannungswerte in einem Brennstoffzellensystem zur Erzeugung von Elektrizität mit Brennstoffzellen, wobei jede Brennstoffzelle in dem Brennstoffzellensystem eine Anodenseite (100), eine Kathodenseite (102) und einen Elektrolyt (104) zwischen der Anodenseite und der Kathodenseite umfasst, und das Brennstoffzellensystem mindestens ein Brennstoffzellenfeld (103) aus mindestens zwei Brennstoffzellen und mindestens eine Last (146) zum Durchführen der Lastfunktion umfasst, wobei die Offset-Steueranordnung Spannungsüberwachungsmittel (142) zum Überwachen der Eingangsspannung der Last (146), um Überwachungsinformationen zu erhalten, einen Steuerprozessor (120) zum Verarbeiten der Überwachungsinformationen und mindestens eine versetzende Quelle (140) in Reihenverbindung mit dem mindestens einen Brennstoffzellenfeld (103) umfasst, wobei der Leistungspegel der versetzenden Quelle (140) im Vergleich zum Leistungspegel des Brennstoffzellenfeldes (103) im Wesentlichen niedrig ist, und die versetzende Quelle (140) angeordnet ist, um mindestens eine unidirektionale Verschiebung der Brennstoffzellenfeld-Ausgangsspannung durchzuführen, um das für die Last (146) ersichtliche Spannungsfenster auf der Grundlage von mindestens einem von den Überwachungsinformationen und den verarbeiteten Überwachungsinformationen zu verringern, **dadurch gekennzeichnet, dass** die Offset-Steueranordnung ferner Mittel (144) zum Trennen des mindestens einen Brennstoffzellenfeldes (103) von der Last (146) umfasst, wenn ein Grund für die Trennung in der Eingangsspannungsüberwachung der Last durch Ermitteln, dass die Eingangsspannung außerhalb von zulässigen Grenzen ansteigt, ermittelt wird.

2. Offset-Steueranordnung nach Anspruch 1, **dadurch gekennzeichnet, dass** das Brennstoffzellensystem mindestens zwei elektrisch parallel verbundene Brennstoffzellenfelder (103) umfasst und die Offset-Steueranordnung mindestens eine getrennte versetzende Quelle (140) für jedes Feld (103) zum Bereitstellen einer individuellen Kompensation für jedes Feld umfasst.

3. Offset-Steueranordnung nach Anspruch 1, **dadurch gekennzeichnet, dass** die Offset-Steueranordnung eine negativ versetzende Quelle (140a) zum Bereitstellen von mindestens einem negativ versetzenden Wert für das mindestens eine Brennstoffzellenfeld (103) umfasst.

4. Offset-Steueranordnung nach Anspruch 1, **dadurch gekennzeichnet, dass** die Offset-Steueranordnung eine positiv versetzende Quelle (140b) zum Bereitstellen von mindestens einem positiv versetzenden Wert für das mindestens eine Brennstoffzellenfeld (103) hauptsächlich für den Betrieb am Ende der Lebensdauer umfasst.

5. Offset-Steueranordnung nach Anspruch 2, **dadurch gekennzeichnet, dass** die Offset-Steueranordnung eine separate versetzende Quelle (140) für jedes Brennstoffzellenfeld (103) und eine gemeinsame versetzende Quelle (140) mit einer Polarität, die derjenigen der separaten versetzenden Quelle entgegengesetzt ist, für alle Felder (103) oder für die meisten der Felder (103) umfasst.

6. Offset-Steueranordnung nach Anspruch 2, **dadurch gekennzeichnet, dass** die Offset-Steueranordnung den Steuerprozessor (120) zur Bewerkstelligung von Stromaufteilungssteuerung zwischen den mindestens zwei Brennstoffzellenfeldern (103) durch Bereitstellen von mindestens einem von einem Stromsollwert und einem Spannungssollwert für eine positiv versetzende Quelle (140b) für den kontinuierlichen Betrieb des Brennstoffzellensystems und durch Steuern von mindestens einem von der Spannung und dem Strom einer negativ versetzenden Quelle (140a) umfasst, derart, dass für das Brennstoffzellenfeld (103) mit der besten Leistung wenig oder kein positives Versetzen bewerkstelligt wird, und wobei die negativ versetzende Quelle (140a) hauptsächlich während des Anlaufverfahrens des Brennstoffzellensystems aktiv ist.

7. Offset-Steueranordnung nach Anspruch 1, **dadurch gekennzeichnet, dass** die Offset-Steueranordnung die Spannungsüberwachungsmittel (142) in der negativ versetzenden Quelle (140a) durch Verwenden von Steuerschaltungen (141) der negativ versetzenden Quelle (140a) als das Überwachungsmittel (142) umfasst, wobei die Steuerschaltungen (141) mindestens ein Hauptbrennstoffzellenfeld-Schaltschütz (144) als das Mittel (144) zum Trennen der mindestens einen Brennstoffzellenanordnung (103) von der Last (146) steuert, wenn durch das Überwachen ein Grund für die Trennung in dem Brennstoffzellensystem ermittelt wird.

8. Offset-Steueranordnung nach Anspruch 1, **dadurch gekennzeichnet, dass** die Offset-Steueranordnung eine einzelne versetzende Quelle (140) umfasst, die für eine bipolare Ausgangsspannung zur Durchführung von bipolarer Offset-Kompensation in der Lage ist.

9. Offset-Steueranordnung nach Anspruch 1, **dadurch gekennzeichnet, dass** die Offset-Steueranordnung zwei unipolare versetzende Quellen (140) in Reihe und mit gegenseitig umgekehrten Polaritäten zum Durchführen von bipolarer Offset-Kompensation umfasst.

10. Offset-Steuerverfahren zum Steuern von Spannungswerten in einem Brennstoffzellensystem zum Erzeugen von Elektrizität mit Brennstoffzellen, wobei jede Brennstoffzelle in dem Brennstoffzellensystem eine Anodenseite (100), eine Kathodenseite (102) und einen Elektrolyt (104) zwischen der Anodenseite und der Kathodenseite umfasst, wobei in dem Verfahren Eingangsspannung einer Last (146) des Brennstoffzellensystems überwacht wird, um Überwachungsinformationen zu erhalten, die verarbeitet werden, mindestens eine versetzende Quelle (140) in Reihenverbindung mit mindestens einem Brennstoffzellenfeld (103) verbunden ist, wobei der Leistungspegel der versetzenden Quelle (140) im Vergleich zum Leistungspegel des Brennstoffzellenfeldes (103) im Wesentlichen niedrig ist, und mindestens eine unidirektionale Verschiebung der Brennstoffzellenfeld-Ausgangsspannung durch die mindestens eine versetzende Quelle (140) durchgeführt wird, um das für die Last (146) ersichtliche Spannungsfenster auf der Grundlage von mindestens einem von den Überwachungsinformationen und den verarbeiteten Überwachungsinformationen zu verringern, **dadurch gekennzeichnet, dass** das mindestens eine Brennstoffzellenfeld (103) von der Last (146) getrennt wird, wenn ein Grund für die Trennung in der Eingangsspannungsüberwachung der Last durch Ermitteln, dass die Eingangsspannung außerhalb zulässiger Grenzen ansteigt, ermittelt wird.

11. Offset-Steuerungsverfahren nach Anspruch 10, **dadurch gekennzeichnet, dass** das mindestens unidirektionale Verschieben der Brennstoffzellenfeld-Ausgangsspannung durch mindestens eine separate versetzende Quelle (140) in mindestens zwei elektrisch parallel verbundenen Brennstoffzellenfeldern (103) durchgeführt wird, um für jedes Feld eine individuelle Kompensation bereitzustellen.

12. Offset-Steuerungsverfahren nach Anspruch 10, **dadurch gekennzeichnet, dass** der mindestens negativ versetzende Wert für das mindestens eine Brennstoffzellenfeld (103) durch eine negativ versetzende Quelle (140a) bereitgestellt wird.

13. Offset-Steuerungsverfahren nach Anspruch 10, **dadurch gekennzeichnet, dass** der mindestens positiv versetzende Wert für das mindestens eine Brennstoffzellenfeld (103) hauptsächlich für den Betrieb am Ende der Lebensdauer durch eine positiv versetzende Quelle (140b) bereitgestellt wird.

14. Offset-Steuerungsverfahren nach Anspruch 10, **dadurch gekennzeichnet, dass** in dem Verfahren eine separate versetzende Quelle (140) für jedes Brennstoffzellenfeld (103) verwendet wird und eine gemeinsame versetzende Quelle (140) mit einer Polarität, die derjenigen der separaten versetzenden Quelle entgegengesetzt ist, für alle Felder (103) oder für die meisten der Felder (103) verwendet wird.

15. Offset-Steuerungsverfahren nach Anspruch 10, **dadurch gekennzeichnet, dass** die Stromaufteilungssteuerung zwischen mindestens zwei Brennstoffzellenfeldern (103) durch Bereitstellen von mindestens einem von einem Stromsollwert und einem Spannungssollwert für eine positiv versetzende Quelle (140b) für den kontinuierlichen Betrieb des Brennstoffzellensystems und durch Steuern von mindestens einem von der Spannung und dem Strom einer negativ versetzenden Quelle (140a) bewerkstelligt wird, derart, dass für das Brennstoffzellenfeld (103) mit der besten Leistung wenig oder kein positives Versetzen bewerkstelligt wird, und wobei die negativ versetzende Quelle (140a) hauptsächlich während des Anlaufverfahrens des Brennstoffzellensystems aktiv ist.

16. Offset-Steuerungsverfahren nach Anspruch 10, **dadurch gekennzeichnet, dass** in dem Verfahren die Eingangsspannung einer Last (146) des Brennstoffzellensystems unter Verwendung von Steuerschaltungen (141) einer negativ versetzenden Quelle (140a) bei dem Überwachen zum Steuern des mindestens einen Hauptbrennstoffzellenfeld-Schaltschütz (144) zum Trennen des mindestens einen Brennstoffzellenfeldes (103) von der Last (146) überwacht wird, wenn durch das Überwachen ein Grund für die Trennung in dem Brennstoffzellensystem ermittelt wird.

17. Offset-Steuerungsverfahren nach Anspruch 10, **dadurch gekennzeichnet, dass** in dem Verfahren eine bipolare Ausgangsspannung der einzelnen versetzenden Quelle (140) verwendet wird, um bipolare Offset-Kompensation durchzuführen.

18. Offset-Steuerungsverfahren nach Anspruch 10, **dadurch gekennzeichnet, dass** in dem Verfahren zwei unipolare versetzende Quellen (140) in Reihe mit gegenseitig umgekehrten Polaritäten verbunden sind, um bipolare Offset-Kompensation durchzuführen.

## Revendications

1. Agencement de commande de décalage pour commander des valeurs de tension dans un système de piles à combustible pour produire de l'électricité avec des piles à combustible, chaque pile à combustible dans le système de piles à combustible comprenant un côté anode (100), un côté cathode (102) et un électrolyte (104) entre le côté anode et le côté cathode, le système de piles à combustibles comprenant au moins un ensemble de piles à combustible (103) d'au moins deux piles à combustible, et au moins une charge (146) pour réaliser une fonction de charge, l'agencement de commande de décalage comprenant des moyens de surveillance de tension (142) pour surveiller une tension d'entrée de la charge (146) afin d'obtenir de l'information de surveillance, un processeur de commande (120) pour traiter ladite information de surveillance, au moins une source de décalage (140) connectée en série audit au moins un ensemble de piles à combustible (103), le niveau de puissance de la source de décalage (140) étant sensiblement bas en comparaison avec le niveau de puissance de l'ensemble de piles à combustible (103), et la source de décalage (140) étant étudiée pour réaliser au moins un changement unidirectionnel d'une tension de sortie de l'ensemble de piles à combustible afin de réduire une fenêtre de tension apparente pour la charge (146) sur la base d'au moins l'une d'entre l'information de surveillance et l'information de surveillance traitée, **caractérisé en ce que** l'agencement de commande de décalage comprend en outre des moyens (144) pour déconnecter cet au moins un ensemble de piles à combustible (103) de la charge (146) si l'on détecte une raison pour la déconnexion lors de la surveillance de la tension d'entrée de la charge en détectant que la tension d'entrée s'élève au-delà des limites autorisées.

2. Agencement de commande de décalage selon la revendication 1, **caractérisé en ce que** le système de piles à combustible comprend au moins deux ensembles de piles à combustible (103) connectés électriquement en parallèle, et l'agencement de commande de décalage comprenant au moins une source de décalage (140) distincte pour chaque ensemble (103) afin de fournir une compensation individuelle pour chaque ensemble.

3. Agencement de commande de décalage selon la revendication 1, **caractérisé en ce que** l'agencement de commande de décalage comprend une source de décalage négatif (140a) pour fournir au moins une valeur de décalage négatif pour cet au moins un ensemble de piles à combustible (103).

4. Agencement de commande de décalage selon la revendication 1, **caractérisé en ce que** l'agencement de commande de décalage comprend une source de décalage positif (140b) pour fournir au moins une valeur de décalage positif pour cet au moins un ensemble de piles à combustible (103) principalement pour un fonctionnement en fin de vie.

5. Agencement de commande de décalage selon la revendication 2, **caractérisé en ce que** l'agencement de commande de décalage comprend une source de décalage (140) distincte pour chaque ensemble de piles à combustible (103) et une source de décalage commune (140) à polarité opposée par rapport à ladite source de décalage distincte pour tous les ensembles (103) ou pour la plupart des ensembles (103).

6. Agencement de commande de décalage selon la revendication 2, **caractérisé en ce que** l'agencement de commande de décalage comprend le processeur de commande (120) pour accomplir une commande de répartition de courant entre ces au moins deux ensembles de piles à combustible (103) en fournissant au moins l'un d'entre un point de réglage de courant et un point de réglage de tension à une source de décalage positif (140b) pour un fonctionnement en continu du système de piles à combustible, et en commandant au moins l'un/l'une d'entre une tension et un courant d'une source de décalage négatif (140a) de manière à ce que, pour l'ensemble de piles à combustible (103) réalisant la meilleure performance, un faible décalage positif est réalisé ou aucun décalage positif n'est réalisé, et laquelle source de décalage négatif (140a) étant principalement active pendant le processus de démarrage du système de piles à combustible.

7. Agencement de commande de décalage selon la revendication 1, **caractérisé en ce que** l'agencement de commande de décalage comprend les moyens de surveillance de tension (142) dans la source de décalage négatif (140a) en utilisant des circuits de commande (141) de la source de décalage négatif (140a) en tant que lesdits moyens de surveillance (142), lesquels circuits de commande (141) commandant au moins un contacteur principal d'ensemble de piles à combustibles (144) en tant que moyen (144) pour déconnecter cet au moins un ensemble de piles à combustible (103) de la charge (146) si l'on détecte une raison pour la déconnexion dans le système de piles à combustible grâce à ladite surveillance.

8. Agencement de commande de décalage selon la revendication 1, **caractérisé en ce que** l'agencement de commande de décalage comprend une source de décalage (140) individuelle capable d'une tension de sortie bipolaire pour effectuer une compensation de décalage bipolaire.

9. Agencement de commande de décalage selon la revendication 1, **caractérisé en ce que** l'agencement de commande de décalage comprend deux sources de décalage unipolaires (140), en série, et avec des polarités mutuellement inversées afin de réaliser une compensation de décalage bipolaire.

10. Procédé de commande de décalage pour commander des valeurs de tension dans un système de piles à combustible pour produire de l'électricité avec des piles à combustible, chaque pile à combustible dans le système de piles à combustible comprenant un côté anode (100), un côté cathode (102) et un électrolyte (104) entre le côté anode et le côté cathode, dans lequel, dans le procédé, on surveille une tension d'entrée d'une charge (146) du système de piles à combustible afin d'obtenir de l'information de surveillance qui est traitée, au moins une source de décalage (140) étant connectée, en connexion en série, à au moins un ensemble de piles à combustible (103), le niveau de puissance de la source de décalage (140) étant sensiblement bas en comparaison au niveau de puissance de l'ensemble de piles à combustible (103), et au moins un changement unidirectionnel d'une tension de sortie de l'ensemble de piles à combustible étant réalisé grâce à cette au moins une source de décalage (140) afin de réduire une fenêtre de tension apparente pour la charge (146) sur la base d'au moins l'une d'entre l'information de surveillance et l'information de surveillance traitée, **caractérisé en ce que** cet au moins un ensemble de piles à combustible (103) est déconnecté de la charge(146) si l'on détecte une raison pour la déconnexion lors de la surveillance de la tension d'entrée de la charge en détectant que la tension d'entrée s'élève au-delà des limites autorisées.

11. Procédé de commande de décalage selon la revendication 10, **caractérisé en ce que** l'on effectue au moins un changement unidirectionnel de la tension de sortie d'ensemble de piles à combustible grâce à au moins une source de décalage (140) distincte dans au moins deux ensembles de piles à combustible (103) connectés électriquement en parallèle afin de fournir une compensation individuelle pour chaque ensemble.

12. Procédé de commande de décalage selon la revendication 10, **caractérisé en ce que** l'on fournit au moins une valeur de décalage négatif pour cet au moins un ensemble de piles à combustible (103) grâce à une source de décalage négatif (140a).

13. Procédé de commande de décalage selon la revendication 10, **caractérisé en ce que** l'on fournit au moins une valeur de décalage positif pour cet au moins un ensemble de piles à combustible (103) principalement pour un fonctionnement en fin de vie grâce à une source de décalage positif (140b).

14. Procédé de commande de décalage selon la revendication 10, **caractérisé en ce que**, dans le procédé, on utilise une source de décalage (140) distincte pour chaque ensemble de piles à combustible (103), et une source de décalage commune (140) de polarité opposée à celle de ladite source de décalage distincte étant utilisée pour tous les ensembles (103) ou pour la plupart des ensembles (103).

15. Procédé de commande de décalage selon la revendication 10, **caractérisé en ce qu'**une commande de répartition de courant est réalisée entre au moins deux ensembles de piles à combustible (103) en fournissant au moins l'un d'entre un point de réglage de courant et un point de réglage de tension à une source de décalage positif (140b) pour le fonctionnement en continu du système de piles à combustible, et en commandant au moins l'un/l'une d'entre une tension et un courant d'une source de décalage négatif (140a) de manière à ce que, pour l'ensemble de piles à combustible (103) réalisant la meilleure performance, un faible décalage positif est réalisé ou aucun décalage positif n'est réalisé, et laquelle source de décalage négatif (140a) étant principalement active pendant un processus de démarrage du système de piles à combustible.

16. Procédé de commande de décalage selon la revendication 10, **caractérisé en ce que**, dans le procédé, on surveille une tension d'entrée d'une charge (146) du système de piles à combustible en utilisant des circuits de commande (141) d'une source de décalage négatif (140a) lors de ladite surveillance afin de commander au moins un contacteur principal d'ensemble de piles à combustible (144) pour déconnecter cet au moins un ensemble de piles à combustible (103) de la charge (146) si l'on détecte une raison pour la déconnexion dans le système de piles à combustible grâce à ladite surveillance.

17. Procédé de commande de décalage selon la revendication 10, **caractérisé en ce que**, dans le procédé, on utilise une tension de sortie bipolaire de la source de décalage individuelle (140) afin de réaliser une compensation de décalage bipolaire.

18. Procédé de commande de décalage selon la revendication 10, **caractérisé en ce que**, dans le procédé, on connecte deux sources de décalage unipolaires (140) en série avec des polarités mutuellement inversées afin de réaliser une compensation de décalage bipolaire.
